(19) Europäisches Patentamt / European Patent Office / Office européen des brevets

(11) **EP 3 667 345 B1**

(12) **FASCICULE DE BREVET EUROPEEN**

(45) Date de publication et mention
de la délivrance du brevet:
**21.04.2021 Bulletin 2021/16**

(51) Int Cl.:
*G01R 31/392* (2019.01)     *G01R 31/396* (2019.01)

(21) Numéro de dépôt: **19215424.3**

(22) Date de dépôt: **11.12.2019**

(54) **PROCÉDÉ DE DÉTERMINATION DE L'ÉTAT DE SANTÉ DES CELLULES D'UNE BATTERIE**

VERFAHREN ZUR BESTIMMUNG DES GESUNDHEITSZUSTANDS DER ZELLEN EINER BATTERIE

METHOD FOR DETERMINING THE STATE OF HEALTH OF THE CELLS OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.12.2018 FR 1872806**

(43) Date de publication de la demande:
**17.06.2020 Bulletin 2020/25**

(73) Titulaire: **Commissariat à l'Energie Atomique et aux Energies Alternatives
75015 Paris (FR)**

(72) Inventeur: **CROUZEVIALLE, Bruno
38054 GRENOBLE CEDEX 9 (FR)**

(74) Mandataire: **Cabinet Beaumont
4, Place Robert Schuman
B.P. 1529
38025 Grenoble Cedex 1 (FR)**

(56) Documents cités:
**CN-A- 106 526 495      US-A1- 2014 077 764
US-A1- 2015 106 044**

**Description**

Domaine technique

La présente description concerne le domaine des batteries électriques de façon générale, et vise plus particulièrement la détermination de l'état de santé ou état de vieillissement des cellules d'une batterie.

Technique antérieure

Une batterie électrique est un groupement de plusieurs cellules rechargeables reliées en série et/ou en parallèle entre deux noeuds ou bornes de fourniture de tension.

Dans certaines applications, on souhaite pouvoir estimer, pour chaque cellule d'une batterie, un indicateur représentatif du vieillissement de la cellule, généralement appelé SOH, de l'anglais "State of Health" pour état de santé. A un instant donné de la vie d'une cellule, le SOH peut être défini comme étant le rapport de la capacité de la cellule (c'est-à-dire la charge maximale qu'est capable de stocker et délivrer la cellule) à l'instant considéré, sur une capacité de référence de la cellule, par exemple sa capacité nominale (c'est-à-dire la capacité indiquée par le constructeur), ou sa capacité mesurée à l'état neuf.

La connaissance du SOH de chaque cellule peut par exemple permettre d'identifier des cellules défectueuses pour les isoler ou les remplacer, ou de recaler ou réajuster les jauges d'état de charge des cellules pour tenir compte du vieillissement des cellules.

La demande de brevet EP3276364 (DD17299/B15316) précédemment déposée par le demandeur décrit une méthode d'estimation du SOH des différentes cellules d'une batterie à partir d'une unique phase de décharge ou de charge complète de la batterie.

Cette méthode nécessite toutefois de mémoriser l'évolution de la tension aux bornes de chacune des cellules de la batterie tout au long de la phase de décharge ou de charge de la batterie. Ceci peut s'avérer contraignant et poser des difficultés dans certaines applications, notamment lorsque le nombre de cellules de la batterie est important, dans la mesure où la quantité de données à mémoriser est alors relativement élevée

D'autres documents pertinents sont US 2014/077764, CN 106 526 495 et US 2015/106044.

Résumé de l'invention

Le mode de réalisation prévoit un procédé de détermination de l'état de santé des cellules d'une batterie comportant une pluralité de cellules reliées en série, ce procédé comportant les étapes suivantes :

a) pendant une phase de décharge ou de charge de la batterie, mesurer la tension Ui aux bornes de chaque cellule ;
b) lorsqu'une première cellule atteint une condition prédéfinie de fin de décharge ou de fin de charge, interrompre la décharge ou la charge de la batterie et mémoriser, pour chaque cellule, la tension Ui de la cellule à la fin de la phase de décharge ou de charge de la batterie ;
c) déterminer une valeur QCi_lim représentative de la capacité de la première cellule ; et
d) déterminer, pour chaque autre cellule de la batterie, à partir de la valeur QCi_lim déterminée à l'étape c) et des tensions de fin de décharge ou de fin de charge Ui mémorisées à l'étape b), en utilisant une fonction mathématique f prédéterminée, une valeur QCi représentative de la capacité de la cellule.

Selon un mode de réalisation, l'étape d) comprend le calcul, pour chaque autre cellule de la batterie, d'une valeur f(ACi), où ACi est un paramètre spécifique à la cellule fonction de la tension de fin de décharge ou de fin de charge Ui de la cellule, mémorisée à l'étape b), ainsi que des tensions de fin de décharge ou de fin de charge d'une ou plusieurs autres cellules de la batterie.

Selon un mode de réalisation, à l'étape d), pour chaque autre cellule, le paramètre ACi est calculé selon la formule suivante :

[Math. 1]

$$ACi = \frac{(Ui - Umin) * Ui}{Umax - Umin}$$

où Ui désigne la tension de fin de décharge ou de fin de charge de la cellule, mémorisée à l'étape b), Umin désigne la tension la plus faible du jeu de tensions Ui mémorisé à l'étape b), et Umax désigne la tension la plus élevée du jeu de tensions Ui mémorisé à l'étape b).

Selon un mode de réalisation, à l'étape d), pour chaque autre cellule de la batterie, la valeur QCi représentative de la capacité de la cellule est calculée à partir de la valeur f(ACi) calculée pour la cellule à l'étape d) et de la valeur QCi_lim déterminée à l'étape c).

Selon un mode de réalisation, à l'étape d), pour chaque autre cellule de la batterie, la valeur QCi représentative de la capacité de la cellule est calculée selon la formule suivante :

[Math. 2]

$$QCi = QCi\_lim * (1 + f(ACi))$$

Selon un mode de réalisation, la fonction f est une fonction polynomiale d'ordre p, où p est un entier supérieur ou égal à 1.

Selon un mode de réalisation, le procédé comporte en outre, après l'étape d), la fourniture, pour chaque autre cellule de la batterie, d'un indicateur d'état de santé de la cellule calculé en tenant compte de ladite valeur QCi représentative de la capacité de la cellule.

Selon un mode de réalisation, le procédé comprend, avant l'étape a), une phase préalable de caractérisation de la batterie comportant les étapes suivantes :

a01) déterminer, pour chaque cellule de la batterie, une valeur représentative de la capacité de la cellule, et une valeur représentative de la tension de fin de décharge ou de fin de charge de la cellule ; et
a02) déterminer la fonction f par régression polynomiale à partir des valeurs déterminées à l'étape a01).

Selon un mode de réalisation, l'étape a01) comprend les étapes successives suivantes :

- pendant une phase de décharge ou de charge de la batterie, mesurer et mémoriser l'évolution de la tension aux bornes de chaque cellule ; et
- lorsqu'une première cellule atteint une condition prédéfinie de fin de décharge ou de fin de charge, interrompre la décharge ou la charge de la batterie, et déterminer, pour chaque autre cellule, la variation de charge ΔQCi subie par la batterie entre le passage de la première cellule à une tension égale à la tension de fin de décharge ou de fin de charge de l'autre cellule et la fin de la phase de décharge ou de charge de la batterie.

Selon un mode de réalisation, l'étape a01) comprend les étapes successives suivantes :

- pendant une phase de décharge ou de charge de la batterie, mesurer la tension aux bornes de chaque cellule ;
- lorsqu'une première cellule atteint une condition prédéfinie de fin de décharge ou de fin de charge, interrompre la décharge ou la charge de la batterie, et mémoriser, pour chaque autre cellule, la tension de la cellule à la fin de la phase de décharge ou de charge de la batterie ;
- calculer un indicateur d'état de santé de la première cellule ;
- sélectionner, dans une bibliothèque de courbes de décharge ou de charge de référence, en fonction de l'indicateur d'état de santé de la première cellule calculé à l'étape c), une courbe de référence représentative de l'évolution de la tension de la première cellule en fonction de la charge extraite de la première cellule ou injectée dans la première cellule ; et
- déterminer, pour chaque autre cellule de la batterie, à partir de la courbe de référence sélectionnée à l'étape d), une estimation de la variation de charge ΔQCi subie par la cellule entre le passage de la première cellule à une tension égale à la tension de fin de décharge ou de fin de charge de l'autre cellule et la fin de la phase de décharge ou de charge de la batterie.

Selon un mode de réalisation, à l'étape a01), pour chaque cellule, la valeur représentative de la capacité de la cellule est déterminée comme étant égale à Qtot+ΔQCi, Qtot étant la charge extraite de la batterie ou injectée dans la batterie entre le début et la fin de la phase de décharge ou de charge de la batterie de l'étape a01).

Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :

la figure 1 est un logigramme illustrant, sous forme de blocs, un exemple d'un procédé de détermination de l'état de santé des cellules d'une batterie selon un mode de réalisation ;

la figure 2 est un logigramme illustrant, sous forme de blocs, un procédé de caractérisation d'une batterie en vue de la mise en oeuvre ultérieure d'un procédé de détermination de l'état de santé des cellules de la batterie ;

la figure 3 est un logigramme illustrant, plus en détail un exemple de mise en oeuvre du procédé de caractérisation de la figure 2 ; et

la figure 4 est un logigramme illustrant, plus en détail un autre exemple de mise en oeuvre du procédé de caractérisation de la figure 2.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses utilisations qui peuvent être faites du SOH des cellules d'une batterie n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

On s'intéresse ici plus particulièrement à la détermination du SOH des cellules d'une batterie comportant plusieurs cellules reliées en série entre une borne positive et une borne négative de la batterie. Les cellules de la batterie sont de préférence identiques aux dispersions de fabrication et de vieillissement près. Chaque cellule peut comporter une unique cellule élémentaire de type pile, accumulateur, etc., ou plusieurs cellules élémentaires reliées en série et/ou en parallèle entre une borne positive et une borne négative de la cellule. Les cellules élémentaires sont par exemple des cellules au lithium, par exemple des cellules de type lithium-ion, lithium-métal-polymère, etc. Plus généralement, les modes de réalisation décrits s'appliquent à toutes ou à la plupart des technologies de cellules élémentaires de batterie connues.

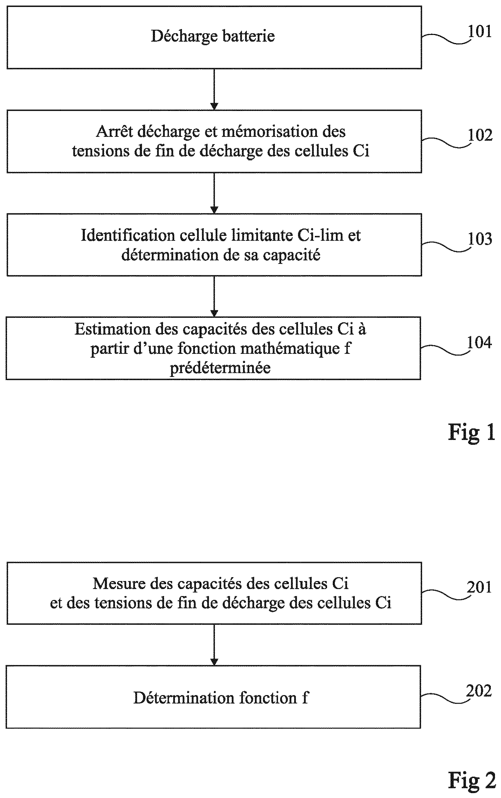

La figure 1 est un logigramme illustrant, sous forme de blocs, un exemple d'un procédé de détermination de l'état de santé des cellules d'une batterie selon un mode de réalisation.

On considère dans cet exemple une batterie (non détaillée sur les figures) comportant n cellules C1, ..., Cn reliées en série entre une borne positive et une borne négative de la batterie, avec n entier supérieur ou égal à 2, par exemple supérieur ou égal à 3.

Un outil de diagnostic (non détaillé sur les figures) est connecté à la batterie, cet outil comportant n capteurs de tension connectés respectivement aux bornes des n cellules $C_i$ de la batterie, avec i entier allant de 1 à n. Chaque capteur de tension est adapté à mesurer la tension $U_i$ aux bornes de la cellule $C_i$ à laquelle il est associé. L'outil de diagnostic peut en outre comporter un compteur coulométrique ou un intégrateur de courant connecté à au moins une borne de la batterie, ou tout autre élément permettant de mesurer ou d'estimer la charge extraite de la batterie lors d'une phase de décharge de la batterie. L'outil de diagnostic comporte en outre des moyens de mémorisation (mémoire, registre, etc.) d'au moins un jeu de n valeurs de tension $U_i$ mesurées respectivement aux bornes des n cellules $C_i$ de la batterie à un instant donné. L'outil de diagnostic peut en outre comporter une unité de traitement pouvant comporter un microprocesseur. En pratique, l'outil de diagnostic peut faire partie d'un dispositif électronique de gestion de la batterie intégré à la batterie, généralement désigné par le terme BMS, de l'anglais "Battery Management System", destiné à mettre en oeuvre des fonctions diverses telles que des fonctions d'équilibrage des cellules, des fonctions de protection, etc. En effet, les composants susmentionnés de l'outil de diagnostic sont des composants que l'on retrouve classiquement dans un dispositif de gestion de batterie de type BMS. A titre de variante, l'outil de diagnostic peut être un dispositif externe à la batterie, destiné à être connecté à la batterie lors d'une phase de diagnostic des cellules de la batterie. Dans une autre variante, l'outil de diagnostic peut être partiellement intégré à la batterie et partiellement externe à la batterie. Par exemple, les capteurs de tension de l'outil de diagnostic peuvent être internes à la batterie, et le dispositif de traitement mettant en oeuvre la méthode décrite à partir des valeurs de tension fournies par les capteurs peut être externe à la batterie. L'outil de diagnostic est configuré pour mettre en oeuvre le procédé de la figure 1 de détermination de l'état de santé des cellules de la batterie.

Le procédé de la figure 1 comprend une étape 101 au cours de laquelle la batterie est soumise à une décharge complète, par exemple à courant constant et à température ambiante constante. Préalablement à l'étape 101, si la batterie n'est pas déjà chargée, une étape de recharge résiduelle de la batterie à son niveau de pleine charge peut être mise en oeuvre. Lors de cette recharge résiduelle, un équilibrage de fin de charge est de préférence réalisé, de façon à ce que les cellules de la batterie présentent toutes sensiblement le même niveau de tension au début de la phase de décharge complète. Les techniques susceptibles d'être utilisées pour réaliser un tel équilibrage de fin de charge sont connues de l'homme du métier et ne seront pas détaillées.

Pendant la phase de décharge complète, l'outil de diagnostic surveille la tension Ui aux bornes de chaque cellule Ci de façon à interrompre la décharge lorsqu'une première cellule Ci de la batterie atteint un seuil de tension basse VL prédéfini, correspondant par exemple à un seuil critique de décharge à ne pas dépasser sous peine d'endommager la cellule. A titre d'exemple, la tension limite basse VL est définie par le fabricant des cellules. La tension VL est par exemple identique pour toutes les cellules de la batterie.

A titre d'exemple, tout au long de la phase de décharge, l'outil de diagnostic lit périodiquement les tensions Ui aux bornes des différentes cellules de la batterie, et vérifie à chaque lecture si l'une des cellules Ci n'a pas atteint son niveau de tension de fin de décharge VL. A chaque itération, les n tensions Ui sont par exemple lues en parallèle (c'est-à-dire simultanément) et mémorisées dans un registre ou une mémoire de l'outil de diagnostic, avant d'être comparées une à une au seuil VL par l'unité de traitement. Si aucune des n tensions Ui mesurées n'est inférieure ou égale au seuil VL, les n valeurs de tensions Ui mémorisées peuvent être écrasées à l'itération suivante (c'est-à-dire remplacées par les n nouvelles valeurs de tension Ui lues). Ainsi, dans cet exemple, seul le dernier jeu de tensions Ui lu par l'outil de diagnostic est conservé en mémoire.

L'outil de diagnostic acquiert en outre, à chaque lecture, la valeur de la charge Q extraite de la batterie depuis le début de la phase de décharge. A titre d'exemple, à chaque itération, seule la dernière valeur lue de la charge extraite Q est conservée en mémoire par l'outil de diagnostic.

Lors d'une étape 102, lorsqu'une première cellule Ci de la batterie atteint son niveau de tension de fin de décharge VL, la décharge de la batterie est interrompue. Le dernier jeu de tensions Ui lu par l'outil de diagnostic est alors conservé en mémoire en vue d'une étape ultérieure d'estimation des capacités des n cellules Ci. La valeur Qtot de la charge extraite de la batterie depuis le début de la phase de décharge est également mémorisée.

Lors d'une étape 103, la cellule Ci ayant atteint en premier son seuil de décharge VL et ayant ainsi provoqué l'arrêt de la décharge de la batterie, est identifiée par l'outil de diagnostic comme étant la cellule limitante Ci_lim de la batterie.

Lors de l'étape 103, l'outil de diagnostic détermine la capacité réelle QCi_lim de la cellule limitante Ci_lim comme correspondant à la charge totale Qtot extraite de la batterie pendant la phase de décharge, qui définit également la capacité de la batterie. Connaissant cette capacité QCi_lim = Qtot, le SOH de la cellule limitante Ci_lim peut être calculé, par exemple comme étant le rapport de la capacité QCi_lim sur une capacité de référence de la cellule.

Lors d'une étape 104, pour chacune des cellules Ci de la batterie à l'exception de la cellule limitante Ci_lim, l'outil de diagnostic estime la capacité réelle QCi de la cellule Ci à partir d'une même fonction mathématique f prédéterminée.

Plus particulièrement, dans le procédé de la figure 1, la fonction f est une fonction polynomiale de la forme :

[Math. 3]

$$\frac{QCi}{QCi\_lim} - 1 = f(ACi) = a_p * ACi^p + a_{p-1} * ACi^{p-1} + a_1 * ACi + a_0$$

où p est un entier supérieur ou égal à 1 désignant l'ordre de la fonction polynomiale f, par exemple égal à 1, 2 ou 3, où $a_p$, $a_{p-1}$, ... $a_1$ et $a_0$ sont les coefficients de la fonction polynomiale f (un ou plusieurs de ces coefficients pouvant être négatifs ou nuls), et où ACi est un paramètre d'entrée de la fonction polynomiale f, spécifique à chaque cellule Ci.

Par fonction mathématique prédéterminée, on entend ici que la fonction f est une fonction mathématique déterminée avant le début du procédé de la figure 1, par exemple avant le début de la phase de décharge de la batterie à l'étape 101. La fonction f peut être déterminée lors d'une phase préalable de caractérisation de la batterie. Des exemples de procédés de caractérisation d'une batterie permettant de déterminer la fonction f seront décrits ci-après en relation avec les figures 2 à 4. Les coefficients $a_p$, $a_{p-1}$, ... $a_1$ et $a_0$ de la fonction f sont par exemple stockés dans une mémoire de l'outil de diagnostic.

Pour chaque cellule Ci (à l'exception de la cellule limitante Ci_lim), l'outil de diagnostic calcule d'abord le paramètre ACi de la cellule, fonction de la tension de fin de décharge Ui de la cellule ainsi que des tensions de fin de décharge d'une ou plusieurs autres cellules de la batterie.

Plus particulièrement, dans cet exemple, le paramètre ACi est défini comme suit :

[Math. 4]

$$ACi = \frac{(Ui - Umin) * Ui}{Umax - Umin}$$

où Umin désigne la tension de fin de décharge la plus faible du jeu de tensions de fin de décharge mémorisé à l'étape 102, c'est-à-dire dans cet exemple la tension de fin de décharge de la cellule limitante, égale au seuil VL de fin de décharge défini pour les cellules de la batterie, et Umax désigne la tension de fin de décharge la plus élevée du jeu de tensions de fin de décharge mémorisé à l'étape 102.

Une fois la valeur ACi calculée, l'outil de diagnostic calcule une valeur QCi représentative de la capacité réelle de la cellule Ci à partir de la fonction f, selon la formule suivante :

[Math. 5]

$$QCi = QCi\_lim * (1 + f(ACi))$$

Connaissant la capacité réelle QCi de la cellule, son SOH peut être calculé par l'outil de diagnostic, par exemple comme étant le rapport de la capacité QCi sur une capacité de référence de la cellule.

Un avantage du procédé décrit en relation avec la figure 1 est qu'il permet d'estimer l'état de santé des différentes cellules d'une batterie à partir d'une unique phase de décharge complète de la batterie, et ce sans avoir à acquérir et enregistrer les courbes de décharge des différentes cellules de la batterie pendant la phase de décharge et sans avoir à faire appel à des bibliothèques de courbes de caractérisation.

De plus, la mise en oeuvre du procédé de diagnostic de la figure 1 ne nécessite la mémorisation que d'un faible nombre de coefficients (égal à l'ordre p de la fonction f) par l'outil de diagnostic pour l'application de la fonction f.

Les essais réalisés ont montré qu'avec une fonction f d'ordre p=2, on obtient une erreur maximale inférieure à plus ou moins 1 % sur la mesure des capacités individuelles (et donc sur le SOH) des cellules d'une batterie de 88 cellules connectées en série, par rapport à une mesure réalisée par la méthode décrite dans la demande de brevet EP3276364 susmentionnée. Cette erreur peut encore être réduite en augmentant l'ordre p de la fonction f.

Cette méthode peut par exemple être mise en oeuvre par un dispositif de gestion intégré à la batterie, pendant le cycle de vie normal de la batterie, pour surveiller l'état de santé des différentes cellules de la batterie, par exemple en vue de planifier d'éventuelles opérations de maintenance de la batterie, pour optimiser l'utilisation de la batterie, ou pour prévenir un éventuel disfonctionnement.

La fonction f peut être déterminée par apprentissage lors d'une phase de caractérisation de la batterie.

L'apprentissage peut être mis en oeuvre par un outil de caractérisation de même nature que l'outil de diagnostic, qui peut être distinct de l'outil de diagnostic ou comporter des éléments communs avec l'outil de diagnostic. A titre d'exemple, l'outil de caractérisation est connecté à la batterie uniquement lors de l'apprentissage, pour générer ou mettre à jour les coefficients $a_p$, $a_{p-1}$, ... $a_1$ et $a_0$ mémorisés par l'outil de diagnostic.

La figure 2 est un logigramme illustrant, sous forme de blocs, un exemple d'un tel procédé de caractérisation.

Le procédé d'apprentissage de la figure 2 comprend une première étape 201 au cours de laquelle on détermine, par toute méthode adaptée, une valeur représentative de la capacité réelle QCi de chaque cellule de la batterie, ainsi qu'une valeur représentative de la tension de fin de décharge Ui de chaque cellule.

Lors d'une étape 202, le procédé de caractérisation détermine la fonction f à partir des capacités QCi et des tensions de fin de décharge Ui déterminées à l'étape 201.

Lors de l'étape 202, pour chaque cellule Ci, le paramètre ACi est calculé selon la formule Math. 4 susmentionnée. De plus, pour chaque cellule Ci, le terme (QCi/QCi_lim)-1, représentatif de l'écart entre la capacité QCi de la cellule et la capacité de la cellule limitante, est calculé. On dispose ainsi d'une courbe discrétisée représentative de l'évolution, en fonction du paramètre ACi, de l'écart (QCi/QCi_lim)-1 entre la capacité QCi d'une cellule et la capacité de la cellule limitante.

La fonction mathématique f est ensuite déterminée par régression polynomiale à partir de cette courbe, l'ordre p du polynôme étant choisi en fonction de la précision d'estimation du SOH souhaitée.

Les coefficients $a_p$, $a_{p-1}$, ... $a_1$ et $a_0$ de la fonction f calculés à l'étape 202 peuvent ensuite être stockés dans une mémoire de l'outil de diagnostic en vue de la mise en oeuvre du procédé de la figure 1.

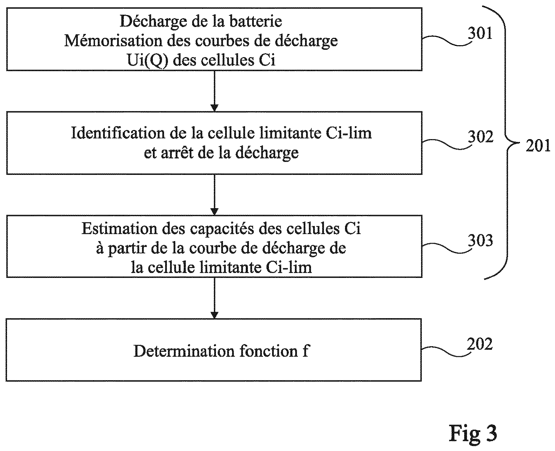

La figure 3 est un logigramme illustrant plus en détail, sous forme de blocs, un exemple de mise en oeuvre du procédé de la figure 2. Plus particulièrement, la figure 3 détaille un exemple de mise en oeuvre de l'étape 201 de détermination des capacités QCi et des tensions de fin de décharge Ui des cellules de la batterie.

Dans cet exemple, le procédé mis en oeuvre à l'étape 201 est un procédé du type décrit dans la demande de brevet EP3276364 susmentionnée, comprenant :

- une étape 301 de décharge de la batterie pendant laquelle l'outil de caractérisation mesure et mémorise l'évolution de la tension Ui aux bornes de chaque cellule Ci en fonction de la charge Q extraite de la batterie ;
- une étape 302 d'interruption de la décharge ou de la charge lorsqu'une première cellule Ci appelée cellule limitante Ci_lim atteint une condition prédéfinie de fin de décharge ; et
- une étape 303 de détermination, à partir de la courbe de décharge de la cellule limitante Ci_lim, pour chaque autre cellule Ci de la batterie, de la variation de charge ΔQCi subie par la batterie entre le passage de la cellule limitante (Ci_lim) à une tension égale à la tension de fin de décharge Ui de l'autre cellule Ci et la fin de la phase de décharge.

Pour chaque cellule Ci, la valeur ΔQCi déterminée à l'étape 303, par projection de la tension de fin de décharge Ui de la cellule sur la courbe de décharge de la cellule limitante, est ajoutée à la charge totale Qtot extraite de la batterie pendant la phase de décharge pour obtenir une estimation QCi de la capacité réelle de la cellule Ci. Les tensions de fin de décharge Ui correspondent quant à elles aux dernières tensions mesurées aux bornes des cellules Ci avant l'arrêt de la décharge à l'étape 302.

La fonction f est ensuite déterminée à l'étape 202 à partir des valeurs QCi et Ui ainsi générées.

De préférence, dans le procédé de caractérisation de la figure 3, les conditions de courant et de température dans lesquelles la batterie est déchargée à l'étape 301 sont sensiblement identiques aux conditions de décharge de la batterie à l'étape 101 du procédé de la figure 1.

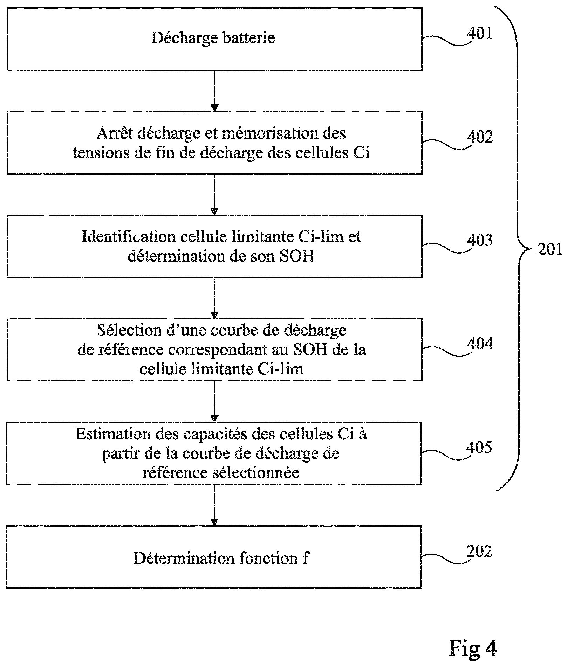

La figure 4 est un logigramme illustrant, sous forme de blocs, un autre exemple de mise en oeuvre du procédé de la figure 2. Plus particulièrement, la figure 4 détaille un autre exemple de mise en oeuvre de l'étape 201 de détermination des capacités QCi et des tensions de fin de décharge Ui des cellules de la batterie.

Dans cet exemple, le procédé mis en oeuvre à l'étape 201 comprend des étapes 401, 402, 403, 404 et 405.

Lors de l'étape 401, la batterie est soumise à une décharge complète. Pendant la phase de décharge complète, l'outil de caractérisation surveille la tension Ui aux bornes de chaque cellule Ci de façon à interrompre la décharge lorsqu'une première cellule Ci de la batterie atteint un seuil de décharge VL prédéfini. A titre d'exemple, tout au long de la phase de décharge, l'outil de caractérisation lit périodiquement les tensions Ui aux bornes des différentes cellules de la batterie, et vérifie à chaque lecture si l'une des cellules Ci n'a pas atteint son niveau de tension de fin de décharge VL. Dans cet exemple, seul le dernier jeu de tensions Ui lu par l'outil de caractérisation est conservé en mémoire. Autrement dit, à la différence du procédé de la figure 3, dans l'exemple de la figure 4, l'outil de caractérisation ne mémorise pas les courbes de décharge Ui(Q) des différentes cellules de la batterie. L'outil de caractérisation peut en outre acquérir, à chaque itération, la valeur de la charge Q extraite de la batterie depuis le début de la phase de décharge. A titre d'exemple, à chaque itération, seule la dernière valeur lue de la charge extraite Q est conservée en mémoire par l'outil de caractérisation.

Lors d'une étape 402, lorsqu'une première cellule Ci de la batterie atteint son niveau de tension de fin de décharge VL, la décharge de la batterie est interrompue. Le dernier jeu de tensions Ui lu par l'outil de caractérisation est alors conservé en mémoire en vue d'une étape ultérieure d'estimation des capacités des n cellules Ci. La valeur Qtot de la charge extraite de la batterie depuis le début de la phase de décharge est également mémorisée.

Lors d'une étape 403, la cellule Ci ayant atteint en premier son seuil de décharge VL et ayant ainsi provoqué l'arrêt de la décharge de la batterie, est identifiée par l'outil de caractérisation comme étant la cellule limitante Ci_lim de la batterie. Lors de l'étape 403, l'outil de caractérisation détermine le SOH de la cellule limitante Ci_lim à partir de la valeur Qtot de la charge totale extraite de la batterie pendant la phase de décharge, qui correspond à la capacité réelle de la cellule limitante. Connaissant cette capacité Qtot, le SOH de la cellule limitante Ci_lim peut être calculé, par exemple comme étant le rapport de la capacité Qtot sur une capacité de référence de la cellule.

Dans l'exemple de la figure 4, l'outil de caractérisation comprend une mémoire stockant une bibliothèque de courbes de décharge de référence d'une cellule élémentaire du type utilisé pour réaliser la batterie, pour différents états de santé de la cellule. La bibliothèque de courbes de référence peut être mémorisée par l'outil de caractérisation sous la forme d'un ensemble de tables de mémorisation, chaque table correspondant à une courbe de décharge et stockant un ensemble discret de valeurs U(Q) de la courbe de décharge. Les courbes de décharge peuvent être fournies par le fabricant des cellules, ou être mesurées expérimentalement en laboratoire sur une cellule unitaire de référence que l'on pourra faire cycler un grand nombre de fois de façon à balayer les différentes valeurs de SOH visées. A titre d'exemple, la gamme de valeurs de SOH balayées s'étend depuis l'état neuf, à savoir 100 %, jusqu'à une valeur basse inférieure ou égale à 70 %, par exemple inférieure ou égale à 60 %, par pas de 10 % ou moins, par exemple par pas de 5 % ou moins.

Lors d'une étape 404, l'outil de caractérisation sélectionne, dans sa bibliothèque de courbes de décharge de référence, une courbe de décharge de référence représentative de l'évolution de la tension d'une cellule en fonction de la charge extraite de la cellule, pour la valeur de SOH de la cellule limitante Ci_lim déterminée à l'étape 403. Dans le cas où la valeur exacte de SOH déterminée à l'étape 103 n'est pas disponible dans la bibliothèque, l'outil de caractérisation sélectionne par exemple la courbe de référence disponible pour la valeur de SOH la plus proche de la valeur déterminée à l'étape 403, ou encore la courbe de référence disponible pour la plus grande valeur de SOH strictement inférieure à la valeur déterminée à l'étape 403.

Lors d'une étape 405, pour chacune des cellules Ci de la batterie à l'exception de la cellule limitante Ci_lim, l'outil de caractérisation estime la capacité réelle de la cellule Ci à partir de la courbe de décharge de référence sélectionnée à l'étape 404, selon une méthode d'estimation similaire à celle utilisée à l'étape 303 de la figure 3. Plus particulièrement, lors de l'étape 405, l'outil de caractérisation estime, pour chaque cellule Ci de la batterie autre que la cellule limitante Ci_lim), par projection de la tension de fin de décharge Ui de la cellule sur la courbe de décharge de référence sélectionnée à l'étape 404, la variation de charge ΔQCi subie par la batterie entre le passage de la cellule limitante (Ci_lim) à une tension égale à la tension de fin de décharge Ui de l'autre cellule Ci et la fin de la phase de décharge.

Pour chaque cellule Ci, la valeur ΔQCi est ajoutée à la charge totale Qtot extraite de la batterie pendant la phase de décharge de façon à obtenir une estimation QCi de la capacité réelle de la cellule Ci. Les tensions de fin de décharge Ui correspondent quant à elles aux dernières tensions mesurées aux bornes des cellules Ci avant l'arrêt de la décharge à l'étape 402.

La fonction f est ensuite déterminée à l'étape 202 à partir des valeurs QCi et Ui ainsi générées.

De préférence, dans le procédé de caractérisation de la figure 4, les conditions de courant et de température pour lesquelles la courbe de décharge de référence sélectionnée à l'étape 404 a été tracée sont sensiblement identiques aux conditions de courant et de température dans lesquelles la batterie est déchargée à l'étape 401, qui sont elles-mêmes sensiblement identiques aux conditions de courant et de température dans lesquelles la batterie est déchargée à l'étape 101 du procédé de la figure 1.

Des modes de réalisation particuliers ont été décrits. Diverses variantes et modifications apparaîtront à l'homme de l'art. En particulier, bien que l'on ait décrit ci-dessus, en relation avec la figure 1, une méthode de diagnostic réalisée à partir d'une phase de décharge complète de la batterie, précédée le cas échant d'une charge résiduelle de la batterie jusqu'à son niveau de pleine charge, une méthode similaire peut être mise en oeuvre à partir d'une décharge résiduelle de la batterie depuis un niveau de charge quelconque jusqu'à son niveau de décharge, suivie d'une phase de recharge complète de la batterie. Comme dans l'exemple décrit en relation avec la figure 1, la décharge résiduelle (étape 101) est alors interrompue lorsqu'une première cellule atteint son seuil de décharge VL, et les tensions Ui de fin de décharge des n cellules Ci sont mémorisées (étape 102). A ce stade, la capacité de la cellule limitante (étape 103) ne peut toutefois pas encore être déterminée. Il faut en effet attendre la fin de la phase subséquente de recharge complète de la batterie pour connaître la capacité totale Qtot de la batterie et donc estimer la capacité de la cellule limitante. Une fois la recharge complète terminée et la capacité de la cellule limitante déterminée, l'étape 104 est mise en oeuvre de façon identique ou similaire à ce qui a été décrit ci-dessus, en se basant sur la capacité de la cellule limitante estimée à l'issue de la phase de recharge complète de la batterie et sur les tensions de fin de décharge Ui mémorisées à l'issue de l'étape de décharge résiduelle de la batterie pour estimer les capacités réelles QCi des différentes cellules.

Dans une autre variante, plutôt que d'estimer les capacités QCi des cellules Ci à partir des tensions Ui mesurées à la fin d'une phase de décharge (complète ou résiduelle) de la batterie, on peut prévoir d'adapter le procédé de diagnostic décrit ci-dessus pour calculer les capacités QCi des cellules Ci à partir des tensions Ui mesurées à la fin d'une phase de recharge de la batterie.

A titre d'exemple, un procédé similaire à ce qui a été décrit en relation avec la figure 1 peut être mis en oeuvre à partir d'une phase de charge complète de la batterie. Pour cela, la batterie peut être au préalable déchargée jusqu'à son seuil de décharge. Un équilibrage de fin de décharge peut en outre être réalisé de façon que, au début de la phase de charge complète de la batterie, les différentes cellules Ci de la batterie aient sensiblement le même niveau de tension. Pendant la phase de recharge complète de la batterie, l'outil de diagnostic lit périodiquement la tension Ui aux bornes de chaque cellule de la batterie, et mesure la charge injectée dans la batterie depuis le début de la phase de recharge. Lorsqu'une première cellule ou cellule limitante Ci_lim atteint son niveau de pleine charge, correspondant par exemple à la tension maximale que peut supporter la cellule sans dégradation, la recharge de la batterie est interrompue, et les valeurs des tensions Ui des n cellules de la batterie sont mémorisées. La charge Qtot injectée dans la batterie depuis le début de la phase de recharge correspond à la capacité réelle de la cellule Ci_lim, qui définit la capacité de la batterie. A partir de cette valeur Qtot et des tensions de fin de charge Ui des cellules de la batterie, de façon similaire à ce qui a été décrit en relation avec la figure 1 (étape 104), l'outil de diagnostic estime la capacité QCi de chaque cellule sur la base d'une fonction mathématique f prédéfinie.

Le procédé de caractérisation utilisé pour déterminer la fonction f est adapté en conséquence. Plus particulièrement, la fonction f peut être déterminée par un procédé de caractérisation similaire à ce qui a été décrit en relation avec la figure 2, mais en utilisant comme tensions Ui les tensions de fin de charge des cellules à la place des tensions de fin de décharge.

A titre d'exemple, un procédé de caractérisation similaire à ce qui a été décrit en relation avec la figure 3 peut être mis en oeuvre, en remplaçant l'étape 301 de décharge par une étape de recharge de la batterie.

A titre de variante, un procédé de caractérisation similaire à ce qui a été décrit en relation avec la figure 4 peut être mis en oeuvre, en remplaçant l'étape 401 de décharge de la batterie par une étape de recharge de la batterie, et en se basant, à l'étape 404, sur une bibliothèque de courbes de recharge de référence plutôt que sur une bibliothèque de courbes de décharge de référence.

Une méthode de diagnostic similaire peut être mise en oeuvre à partir d'une recharge résiduelle de la batterie depuis un niveau de décharge quelconque, suivie d'une phase de décharge complète de la batterie. Dans ce cas, la recharge résiduelle est interrompue lorsqu'une première cellule atteint son niveau de pleine charge, et les tensions Ui de fin de recharge des n cellules Ci sont mémorisées. A ce stade, la capacité de la cellule limitante ne peut toutefois pas encore être déterminée. Il faut attendre la fin de la phase subséquente de décharge complète de la batterie pour connaître la capacité totale Qtot de la batterie et donc la capacité de la cellule limitante. Une fois la décharge complète terminée et la capacité de la cellule limitante déterminée, l'étape 104 est mise en oeuvre de façon identique ou similaire à ce qui a été décrit ci-dessus, en se basant sur la capacité de la cellule limitante mesurée à l'issue de l'étape de décharge complète de la batterie et sur les tensions de fin de recharge Ui mémorisées à l'issue de l'étape de recharge résiduelle de la batterie pour estimer les capacités QCi des différentes cellules.

Par ailleurs, les modes de réalisation décrits ne se limitent pas aux exemples susmentionnés dans lesquels la fin de la phase de décharge complète ou de recharge complète de la batterie est conditionnée à un passage de la tension de la cellule limitante par un seuil bas (VL) ou haut (non référencé sur les figures). Plus généralement, dans la méthode proposée, la décharge complète ou la charge complète de la batterie peut être interrompue dès lors qu'une condition de fin de décharge ou de fin de charge prédéfinie est satisfaite par une première cellule de la batterie.

**Revendications**

1.  Procédé de détermination de l'état de santé des cellules (Ci) d'une batterie comportant une pluralité de cellules (Ci) reliées en série, ce procédé comportant les étapes suivantes :

    a) pendant une phase (101) de décharge ou de charge de la batterie, mesurer la tension Ui aux bornes de chaque cellule (Ci) ;
    b) lorsqu'une première cellule (Ci_lim) atteint une condition prédéfinie de fin de décharge ou de fin de charge, interrompre (102) la décharge ou la charge de la batterie et mémoriser, pour chaque cellule (Ci), la tension Ui de la cellule à la fin de la phase de décharge ou de charge de la batterie ;
    c) déterminer (103) une valeur QCi_lim représentative de la capacité de la première cellule ; et
    d) déterminer (104), pour chaque autre cellule de la batterie, à partir de la valeur QCi_lim déterminée à l'étape c) et des tensions de fin de décharge ou de fin de charge Ui mémorisées à l'étape b), en utilisant une fonction mathématique f prédéterminée, une valeur QCi représentative de la capacité de la cellule.

2.  Procédé selon la revendication 1, dans lequel l'étape d) comprend le calcul, pour chaque autre cellule (Ci) de la batterie, d'une valeur f(ACi), où ACi est un paramètre spécifique à la cellule fonction de la tension de fin de décharge ou de fin de charge Ui de la cellule, mémorisée à l'étape b), ainsi que des tensions de fin de décharge ou de fin de charge d'une ou plusieurs autres cellules de la batterie.

3.  Procédé selon la revendication 2, dans lequel, à l'étape d), pour chaque autre cellule, le paramètre ACi est calculé selon la formule suivante :

    [Math. 6]

    $$ACi = \frac{(Ui - Umin) * Ui}{Umax - Umin}$$

    où Ui désigne la tension de fin de décharge ou de fin de charge de la cellule, mémorisée à l'étape b), Umin désigne la tension la plus faible du jeu de tensions Ui mémorisé à l'étape b), et Umax désigne la tension la plus élevée du jeu de tensions Ui mémorisé à l'étape b).

4.  Procédé selon la revendication 2 ou 3, dans lequel, à l'étape d), pour chaque autre cellule (Ci) de la batterie, la valeur QCi représentative de la capacité de la cellule est calculée à partir de la valeur f(ACi) calculée pour la cellule à l'étape d) et de la valeur QCi_lim déterminée à l'étape c).

5.  Procédé selon la revendication 4, dans lequel, à l'étape d), pour chaque autre cellule (Ci) de la batterie, la valeur QCi représentative de la capacité de la cellule est calculée selon la formule suivante :

[Math. 7]

$$QCi = QCi\_lim * (1 + f(ACi))$$

**6.** Procédé selon l'une quelconque des revendications 1 à 5, dans lequel la fonction f est une fonction polynomiale d'ordre p, où p est un entier supérieur ou égal à 1.

**7.** Procédé selon l'une quelconque des revendications 1 à 6, comportant en outre, après l'étape d), la fourniture, pour chaque autre cellule (Ci) de la batterie, d'un indicateur d'état de santé de la cellule calculé en tenant compte de ladite valeur QCi représentative de la capacité de la cellule.

**8.** Procédé selon l'une quelconque des revendications 1 à 7, comprenant, avant l'étape a), une phase préalable de caractérisation de la batterie comportant les étapes suivantes :

a01) déterminer, pour chaque cellule (Ci) de la batterie, une valeur (QCi) représentative de la capacité de la cellule, et une valeur représentative de la tension (Ui) de fin de décharge ou de fin de charge de la cellule ; et
a02) déterminer la fonction f par régression polynomiale à partir des valeurs déterminées à l'étape a01).

**9.** Procédé selon la revendication 8, dans lequel l'étape a01) comprend les étapes successives suivantes :

- pendant une phase (301) de décharge ou de charge de la batterie, mesurer et mémoriser l'évolution de la tension (Ui) aux bornes de chaque cellule (Ci) ; et
- lorsque une première cellule (Ci_lim) atteint une condition prédéfinie de fin de décharge ou de fin de charge, interrompre la décharge ou la charge de la batterie, et déterminer, pour chaque autre cellule (Ci), la variation de charge ΔQCi subie par la batterie entre le passage de la première cellule (Ci_lim) à une tension égale à la tension de fin de décharge ou de fin de charge de l'autre cellule (Ci) et la fin de la phase de décharge ou de charge de la batterie.

**10.** Procédé selon la revendication 8, dans lequel l'étape a01) comprend les étapes successives suivantes :

- pendant une phase (401) de décharge ou de charge de la batterie, mesurer la tension (Ui) aux bornes de chaque cellule (Ci) ;
- lorsque une première cellule (Ci_lim) atteint une condition prédéfinie de fin de décharge ou de fin de charge, interrompre (402) la décharge ou la charge de la batterie, et mémoriser, pour chaque autre cellule (Ci), la tension (Ui) de la cellule à la fin de la phase de décharge ou de charge de la batterie ;
- calculer (403) un indicateur d'état de santé de la première cellule (Ci_lim) ;
- sélectionner (404), dans une bibliothèque de courbes de décharge ou de charge de référence, en fonction de l'indicateur d'état de santé de la première cellule (Ci_lim) calculé à l'étape c), une courbe de référence représentative de l'évolution de la tension (U) de la première cellule en fonction de la charge extraite de la première cellule ou injectée dans la première cellule ; et
- déterminer (405), pour chaque autre cellule (Ci) de la batterie, à partir de la courbe de référence sélectionnée à l'étape d), une estimation de la variation de charge ΔQCi subie par la cellule entre le passage de la première cellule (Ci_lim) à une tension (Ui) égale à la tension de fin d décharge ou de fin de charge de l'autre cellule (Ci) et la fin de la phase de décharge ou de charge de la batterie.

**11.** Procédé selon la revendication 9 ou 10, dans lequel, à l'étape a01), pour chaque cellule (Ci), la valeur (QCi) représentative de la capacité de la cellule est déterminée comme étant égale à Qtot+ΔQCi, Qtot étant la charge extraite de la batterie ou injectée dans la batterie entre le début et la fin de la phase de décharge ou de charge de la batterie de l'étape a01).

**Patentansprüche**

**1.** Verfahren zur Bestimmung des Gesundheitszustandes von Zellen (Ci) einer Batterie, die eine Vielzahl von in Reihe geschalteten Zellen (Ci) aufweist, wobei das Verfahren die folgenden Schritte umfasst:

a) während einer Batterieentlade- oder -ladephase (101), Messen der Spannung Ui an Anschlüssen jeder Zelle (Ci);

b) wenn eine erste Zelle (Ci_lim) eine vordefinierte Entladeschluss- oder Ladeschluss-Bedingung erreicht, Unterbrechen (102) der Batterieentladung oder -ladung und Speichern der Spannung Ui der Zelle am Ende der Batterieentladungs- oder -ladephase für jede Zelle (Ci);

c) Bestimmen (103) eines Wertes QCi_lim, der für die Kapazität der ersten Zelle repräsentativ ist; und

d) Bestimmen (104) eines für die Kapazität der Zelle repräsentativen Wertes QCi für jede andere Batteriezelle aus dem in Schritt c) bestimmten Wert QCi_lim und den in Schritt b) gespeicherten Entladeschluss- oder Ladeschluss-Spannungen Ui unter Verwendung einer vorbestimmten mathematischen Funktion f.

2. Verfahren nach Anspruch 1, wobei Schritt d) das Berechnen eines Wertes f(ACi) für jede andere Batteriezelle (Ci) aufweist, wobei ACi ein für die Zelle spezifischer Parameter ist, der eine Funktion der Entladeschluss- oder Ladeschluss-Spannungen Ui der Zelle, die in Schritt b) gespeichert wurden, sowie der Entladeschluss- oder Ladeschluss-Spannungen einer oder mehrerer anderer Zellen der Batterie ist.

3. Verfahren nach Anspruch 2, wobei in Schritt d) für jede andere Zelle der Parameter ACi nach der folgenden Formel berechnet wird:

[Math. 6]

$$ACi = \frac{(Ui-Umin)*Ui}{Umax-Umin}$$

wobei Ui die Entladeschluss-Spannung oder Ladeschluss-Spannung der Zelle bezeichnet, die in Schritt b) gespeichert ist, Umin die niedrigste Spannung in der Menge der Spannungen Ui bezeichnet, die in Schritt b) gespeichert sind, und Umax die höchste Spannung in der Menge der Spannungen Ui bezeichnet, die in Schritt b) gespeichert sind.

4. Verfahren nach Anspruch 2 oder 3, wobei in Schritt d) für jede andere Batteriezelle (Ci) der für die Zellenkapazität repräsentative Wert QCi aus dem für die Zelle in Schritt d) berechneten Wert f(ACi) und dem in Schritt c) bestimmten Wert QCi_lim berechnet wird.

5. Verfahren nach Anspruch 4, wobei in Schritt d) für jede andere Batteriezelle (Ci) der für die Zellenkapazität repräsentative Wert QCi gemäß der folgenden Formel berechnet wird:

[Math. 7]

$$QCi = QCi\_lim * (1 + f(ACi))$$

6. Verfahren nach einem der Ansprüche 1 bis 5, wobei die Funktion f eine Polynomfunktion der Ordnung p ist, wobei p eine ganze Zahl größer als oder gleich 1 ist.

7. Verfahren nach einem der Ansprüche 1 bis 6, wobei ferner nach Schritt d) für jede andere Batteriezelle (Ci) ein Indikator für den Gesundheitszustand der Zelle geliefert wird, der unter Berücksichtigung des für die Zellenkapazität repräsentativen Wertes QCi berechnet wird.

8. Verfahren nach einem der Ansprüche 1 bis 7, das vor dem Schritt a) eine vorhergehende Phase der Batteriecharakterisierung aufweist, die die folgenden Schritte umfasst

a01) Bestimmen, für jede Batteriezelle (Ci), eines Wertes (QCi), der für die Zellenkapazität repräsentativ ist, und eines Wertes, der für die Entladeschluss- oder Ladeschluss-Spannung (Ui) der Zelle repräsentativ ist; und

a02) Bestimmen der Funktion f durch polynomielle Regression aus den in Schritt a01) bestimmten Werten.

9. Verfahren nach Anspruch 8, wobei Schritt a01) die folgenden aufeinanderfolgenden Schritte aufweist:

- während einer Batterieentlade- oder -ladephase (301), Messen und Speichern der Änderung der Spannung (Ui) über jeder Zelle (Ci); und

- wenn eine erste Zelle (Ci_lim) eine vordefinierte Entladeschluss- oder Ladeschluss-Bedingung erreicht, Unterbrechen der Batterieentladung oder -ladung und Bestimmen, für jede andere Zelle (Ci), der von der Batterie durchlaufenen Ladungsänderung ∆QCi zwischen dem Durchgang der ersten Zelle (Ci_lim) zu einer Spannung, die gleich der Entladeschluss- oder Ladeschluss-Spannung der anderen Zelle (Ci) ist, und dem Ende der Batterieentlade- oder -ladephase.

10. Verfahren nach Anspruch 8, wobei Schritt a01) die folgenden aufeinanderfolgenden Schritte aufweist:

- während einer Batterieentlade- oder -ladephase (401), Messen der Spannung (Ui) an Anschlüssen jeder Zelle (Ci);
- wenn eine erste Zelle (Ci_lim) eine vordefinierte Entladeschluss- oder Ladeschluss-Bedingung erreicht, Unterbrechen (402) der Batterieentladung oder -ladung und Speichern, für jede andere Zelle (Ci), der Spannung (Ui) der Zelle am Ende der Batterieentlade- oder -ladephase;
- Berechnen (403) eines Indikators für den Gesundheitszustand der ersten Zelle (Ci_lim);
- Auswählen (404) einer Referenzkurve aus einer Bibliothek von Referenz-Entlade- oder -Ladekurven gemäß dem in Schritt c) berechneten Indikator des Gesundheitszustands der ersten Zelle (Ci_lim), die für die Änderung der Spannung (U) der ersten Zelle gemäß der aus der ersten Zelle entnommenen oder in die erste Zelle eingebrachten Ladung repräsentativ ist; und
- Bestimmen (405), für jede andere Batteriezelle (Ci), aus der in Schritt d) ausgewählten Referenzkurve eine Schätzung der Ladungsänderung ∆QCi, die die Zelle zwischen dem Durchgang der ersten Zelle (Ci_lim) zu einer Spannung (Ui), die gleich der Entladeschluss- oder Ladeschluss-Spannung der anderen Zelle (Ci) ist, und dem Ende der Batterielade- oder Entladephase durchläuft.

11. Verfahren nach Anspruch 9 oder 10, bei dem im Schritt a01) für jede Zelle (Ci) der für die Zellenkapazität repräsentative Wert (QCi) als gleich Qtot+∆QCi bestimmt wird, wobei Qtot die der Batterie entnommene oder in die Batterie eingebrachte Ladung zwischen dem Beginn und dem Ende der Batterieentlade- oder -ladephase des Schritts a01) ist.

**Claims**

1. Method of determining the state of health of the cells (Ci) of a battery comprising a plurality of series- coupled cells (Ci), this method comprising the steps of:

a) during a battery discharge or charge phase (101), measuring the voltage Ui across each cell (Ci);
b) when a first cell (Ci lim) reaches a predefined end-of-discharge or end-of-charge condition, interrupting (102) the battery discharge or charge, and storing, for each cell (Ci), the voltage Ui of the cell at the end of the battery discharge or charge phase;
c) determining (103) a value QCi lim representative of the capacitance of the first cell; and
d) determining (104), for each other battery cell, from the value QCi lim determined at step c) and the end-of-discharge or end-of-charge voltages Ui stored at step b), by using a predetermined mathematical function f, a value QCi representative of the cell capacitance.

2. Method according to claim 1, wherein step d) comprising calculating, for each other battery cell (Ci), a value f(ACi), where ACi is a parameter specific to the cell which is a function of the end-of-discharge or end-of-charge voltages Ui of the cell, stored at step b), as well as of the end-of-discharge or end-of-charge voltages of one or a plurality of other cells of the battery.

3. Method according to claim 2, wherein, at step d), for each other cell, parameter ACi is calculated according to the following formula:

[Math. 6]

$$ACi = \frac{(Ui - Umin) * Ui}{Umax - Umin}$$

where Ui designates the end-of-discharge or end-of-charge voltage of the cell, stored at step b), Umin designates the lowest voltage in the set of voltages Ui stored at step b), and Umax designates the highest voltage in the set of voltages Ui stored at step b).

4. Method according to claim 2 or 3, wherein, at step d), for each other battery cell (Ci), the value QCi representative of the cell capacitance is calculated from the value f(ACi) calculated for the cell at step d) and the value QCi_lim determined at step c).

5. Method according to claim 4, wherein, at step d), for each other battery cell (Ci), the value QCi representative of the cell capacitance is calculated according to the following formula:

[Math. 7]

$$QCi = QCi\_lim * (1 + f(ACi))$$

6. Method according to any of claims 1 to 5, wherein function f is a polynomial function of order p, where p is an integer greater than or equal to 1.

7. Method according to any of claims 1 to 6, further comprising, after step d), the delivery, for each other battery cell (Ci), of an indicator of the state of health of the cell calculated by taking into account said value QCi representative of the cell capacitance.

8. Method according to any of claims 1 to 7, comprising, before step a), a previous phase of battery characterization comprising the steps of:

   a01) determining, for each battery cell (Ci), a value (QCi) representative of the cell capacitance, and a value representative of the end-of-discharge or end-of-charge voltage (Ui) of the cell; and
   a02) determining function f by polynomial regression from the values determined at step a01).

9. Method according to claim 8, wherein step a01) comprises the successive steps of:

   - during a battery discharge or charge phase (301), measuring and storing the variation of the voltage (Ui) across each cell (Ci); and
   - when a first cell (Ci_lim) reaches a predefined end-of-discharge or end-of-charge condition, interrupting the battery discharge or charge, and determining, for each other cell (Ci), the charge variation ΔQCi undergone by the battery between the passage of the first cell (Ci_lim) to a voltage equal to end-of-discharge or end-of-charge voltage of the other cell (Ci) and the end of the battery discharge or charge phase.

10. Method according to claim 8, wherein step a01) comprises the successive steps of:

   - during a battery discharge or charge phase (401), measuring the voltage (Ui) across each cell (Ci);
   - when a first cell (Ci lim) reaches a predefined end-of-discharge or end-of-charge condition, interrupting (402) the battery discharge or charge, and storing, for each other cell (Ci), the voltage (Ui) of the cell at the end of the battery discharge or charge phase;
   - calculating (403) an indicator of the state of health of the first cell (Ci_lim);
   - selecting (404), from a library of reference discharge or charge curves, according to the indicator of the state of health of the first cell (Ci_lim) calculated at step c), a reference curve representative of the variation of the voltage (U) of the first cell according to the charge extracted from the first cell or injected into the first cell; and
   - determining (405), for each other battery cell (Ci), from the reference curve selected at step d), an estimate of the charge variation ΔQCi undergone by the cell between the passage of the first cell (Ci_lim) to a voltage (Ui) equal to the end-of discharge or end-of-charge voltage of the other cell (Ci) and the end of the battery charge or discharge phase.

11. Method according to claim 9 or 10, wherein, at step a01), for each cell (Ci), the value (QCi) representative of the cell capacitance is determined as being equal to Qtot+ΔQCi, Qtot being the charge extracted from the battery or injected into the battery between the beginning and the end of the battery discharge or charge phase of step a01).

| Décharge batterie | 101 |

↓

| Arrêt décharge et mémorisation des tensions de fin de décharge des cellules Ci | 102 |

↓

| Identification cellule limitante Ci-lim et détermination de sa capacité | 103 |

↓

| Estimation des capacités des cellules Ci à partir d'une fonction mathématique f prédéterminée | 104 |

**Fig 1**

| Mesure des capacités des cellules Ci et des tensions de fin de décharge des cellules Ci | 201 |

↓

| Détermination fonction f | 202 |

**Fig 2**

Décharge de la batterie
Mémorisation des courbes de décharge
Ui(Q) des cellules Ci — 301

Identification de la cellule limitante Ci-lim
et arrêt de la décharge — 302

201

Estimation des capacités des cellules Ci
à partir de la courbe de décharge de
la cellule limitante Ci-lim — 303

Determination fonction f — 202

Fig 3

```
┌─────────────────────────────────────────┐
│            Décharge batterie             │──── 401  ╮
└─────────────────────────────────────────┘          │
                    │                                 │
                    ▼                                 │
┌─────────────────────────────────────────┐          │
│     Arrêt décharge et mémorisation des   │──── 402  │
│  tensions de fin de décharge des cellules Ci│        │
└─────────────────────────────────────────┘          │
                    │                                 │
                    ▼                                 │
┌─────────────────────────────────────────┐          │
│   Identification cellule limitante Ci-lim et │── 403 │  ╮
│        détermination de son SOH          │          │  ├ 201
└─────────────────────────────────────────┘          │  │
                    │                                 │
                    ▼                                 │
┌─────────────────────────────────────────┐          │
│       Sélection d'une courbe de décharge │──── 404  │
│    de référence correspondant au SOH de la│        │
│          cellule limitante Ci-lim        │          │
└─────────────────────────────────────────┘          │
                    │                                 │
                    ▼                                 │
┌─────────────────────────────────────────┐          │
│   Estimation des capacités des cellules Ci à│── 405 │
│        partir de la courbe de décharge de│         ╯
│          référence sélectionnée          │
└─────────────────────────────────────────┘
                    │
                    ▼
┌─────────────────────────────────────────┐
│          Détermination fonction f        │──── 202
└─────────────────────────────────────────┘
```

Fig 4

**RÉFÉRENCES CITÉES DANS LA DESCRIPTION**

**Documents brevets cités dans la description**

- EP 3276364 A
- US 2014077764 A
- CN 106526495
- US 2015106044 A